# EUROPEAN PATENT APPLICATION

(11) **EP 2 991 109 A2**
(43) Date of publication of application: **02.03.2016**
(21) Application number: 14197607.6
(22) Date of filing: 12.12.2014
(51) Int. Cl.: H01L 23/522, H01L 49/02

(54) **Integrated capacitor in an integrated circuit**

(30) Priority: 22.07.2014 US 201414337216
(71) Applicant: MediaTek, Inc, Hsin-Chu 300 (TW)
(72) Inventor: Chen, Shi-Bai, 302 Zhubei City, Hsinchu County (TW); Lee, Tung-Hsing, 247 Luzhou Dist., New Taipei City (TW)
(74) Representative: Hoefer & Partner Patentanwälte mbB

(57) **Abstract**

An integrated capacitor includes a semiconductor substrate comprising a trench isolation area; a first interlayer dielectric (ILD) layer covering the trench isolation area; a first electrode plate comprising at least a first contact layer in the first ILD layer, wherein the contact layer is disposed directly on the trench isolation area; a second electrode plate in the first ILD layer; and a capacitor dielectric structure between the first electrode plate and the second electrode plate.

## Description

### Background

The invention relates generally to the field of integrated circuits. More particularly, the invention relates to an integrated capacitor in an integrated circuit.

Passive components such as capacitors are extensively used in integrated circuit (IC) design for radio-frequency (RF) and mixed-signal applications, such as bypassing, inter-stage coupling, and in resonant circuits and filters. One of the most commonly used capacitors is the metal-oxide-metal (MOM) capacitor.

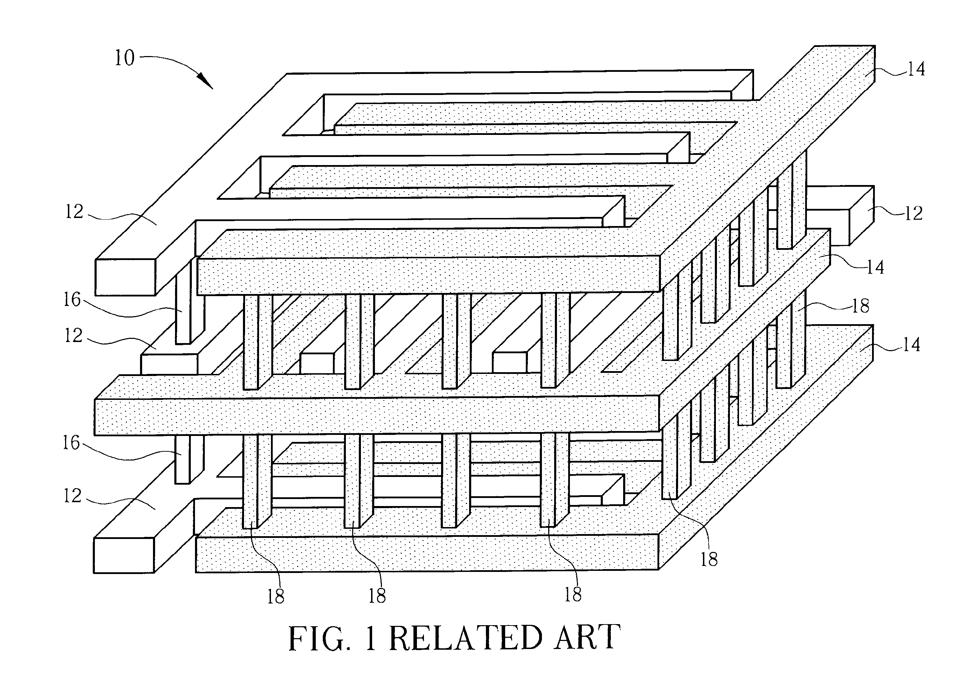

FIG. 1 illustrates a typical MOM capacitor. As shown in FIG. 1, the MOM capacitor 10 includes interdigitated multi-fingers 12 and 14 that are formed in multiple metal layers. The interdigitated multi-fingers are optionally connected by vias 16 and 18 in the vertical BEOL (back-end-of-line) stack separated by inter-metal dielectrics (not explicitly shown). The fabricating process of an MOM capacitor can be integrated with the connect process. Hence, no extra photo mask is required. For example, the dual-damascene techniques typically used with copper multilevel connection metallization on ICs can be used to construct stacks of copper-filled vias and trenches. Two or more such copper-filled vias or trenches, separated by oxide dielectrics, form an MOM capacitor. The entire MOM capacitor 10 is typically fabricated in back-end of line (BEOL) damascened copper layers, for example, M1~Mn (n may typically range between 5~10), which are typically fabricated in extreme low-k (ELK) dielectric layers.

As devices become smaller and circuit density increases, it is desirable that capacitors maintain their level of capacitance while taking up a smaller floor area on the circuit. There is a strong need in this filed to provide such improved integrated MOM capacitor devices without adding any extra photomask.

### Summary

It is one object of the invention to provide an improved MOM capacitor structure that is compatible with current high-K/metal-gate (HK/MG) processes, particularly those high-K/gate-last processes or high-K/gate-last strain enhanced processes.

According to one aspect of the invention, an integrated capacitor is provided. The integrated capacitor includes a semiconductor substrate comprising a trench isolation area; a first interlayer dielectric (ILD) layer covering the trench isolation area; a first electrode plate comprising at least a first contact layer in the first ILD layer, wherein the contact layer is disposed directly on the trench isolation area; a second electrode plate in the first ILD layer; and a capacitor dielectric structure between the first electrode plate and the second electrode plate.

According to the embodiments, the first contact layer is in direct contact with the trench isolation area. According to the embodiments, the second electrode plate comprises a metal gate structure in the first ILD layer. According to the embodiments, the capacitor dielectric structure comprises a sidewall spacer on the metal gate structure. According to the embodiments, the capacitor dielectric structure further comprises a contact etch step layer (CESL) film. According to the embodiments, the capacitor dielectric structure comprises the first ILD layer.

According to the embodiments, the integrated capacitor further includes an etch stop layer on the first ILD layer; a second ILD layer on the etch stop layer; a second contact layer stacked on the first contact layer; and a third contact layer on the metal gate structure, wherein the second and third contact layers are both in the second ILD layer.

According to one aspect of the invention, an integrated capacitor includes a semiconductor substrate comprising a trench isolation area; an interlayer dielectric (ILD) layer covering the trench isolation area; a first electrode plate comprising at least a contact layer in the ILD layer; a second electrode plate in the ILD layer; and a capacitor dielectric structure between the first electrode plate and the second electrode plate.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention, and are incorporated in and constitute a part of this specification. The drawings illustrate embodiments of the invention and, together with the description, serve to explain the principles of the invention. In the drawings:
FIG. 1 illustrates a typical MOM capacitor;
FIGS. 2~4 are schematic sectional view diagrams showing an exemplary method for fabricating an MOM capacitor according to one embodiment of the invention;
FIG. 5 is a schematic layout diagram showing an exemplary MOM capacitor fabricated using the high-K/gate-last process based on the lithographic ground rule;
FIG. 6 is a partial cross-sectional view taken along line I-I' in FIG. 5; and
FIGS. 7~10 are schematic, cross-sectional diagrams showing various MOM capacitors in accordance with different embodiments.

It should be noted that all the figures are diagrammatic. Relative dimensions and proportions of parts of the drawings are exaggerated or reduced in size, for the sake of clarity and convenience. The same reference signs are generally used to refer to corresponding or similar features in modified and different embodiments.

### Detailed Description

One or more implementations of the present invention will now be described with reference to the attached drawings, wherein like reference numerals are used to refer to like elements throughout, and wherein the illustrated structures are not necessarily drawn to scale. The term "horizontal" as used herein is defined as a plane parallel to the conventional major plane or surface of the semiconductor chip or die substrate, regardless of its orientation. The term "vertical" refers to a direction perpendicular to the horizontal as just defined. Terms, such as "on", "above", "below", "bottom", "top", "side" (as in "sidewall"), "higher", "lower", "over", and "under", are defined with respect to the horizontal plane.

The preferred embodiments of this invention will now be explained with the accompanying figures. Throughout the specification and drawings, the symbol "Mn" refers to the topmost level of the copper metal layers fabricated in the integrated circuit chip, while "Mn-1" refers to the copper metal layer that is just one level lower than the topmost copper metal layer and so on, wherein, preferably, n ranges between 5 and 10 but not limited thereto. The symbol "V" refers to the via plug between two adjacent levels of conductive metal layers. For example, V5 refers to the via plug interconnecting M5 to M6, and V0 refers to the via plug interconnecting a contact layer to M1.

The term "front-end of line metal interconnect" or "FEOL metal interconnect" refer to the metal interconnect layers including the contact layer formed during the high-K/gate-last processes, wherein the contact layer interconnects the terminals (e.g. source, drain, or gate electrode) of the transistor devices. The term "back-end of line metal interconnect" or "BEOL metal interconnect" refer to the metal interconnect layers formed after the high-K/gate-last processes, more specifically, after the formation of the contact layer. The high-K/gate-last process is known in the art. The term "gate-last" (also known as "replacement metal gate" or "RMG") refers to that the metal electrode is deposited after the high-temperature activation anneal(s) of the flow.

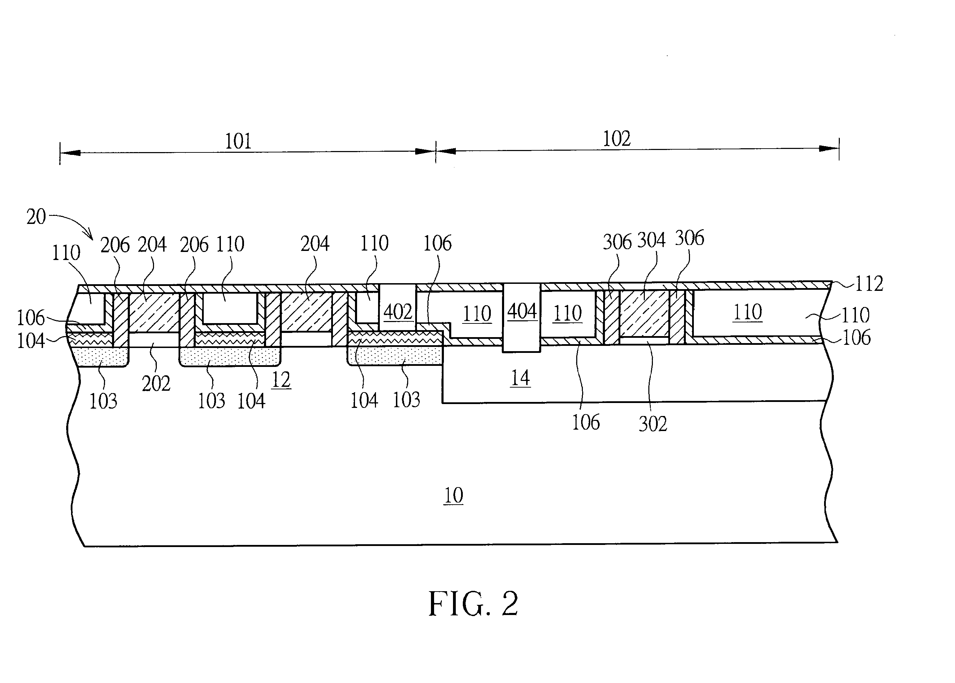

FIGS. 2~4 are schematic sectional view diagrams showing an exemplary method for fabricating an MOM capacitor according to one embodiment of the invention. The fabrication method of the MOM capacitor can be integrated with and compatible with current high-K/gate-last processes or high-K/gate-last strain enhanced processes. First, as shown in FIG. 2, a semiconductor substrate 10 such as a silicon substrate is provided. Metal gated transistor structures 20 are formed within a CMOS region 101 on the oxide define (OD) area 12. The OD area 12 is surrounded by or at least adjacent to a shallow trench isolation (STI) area 14. At least one metal gate structure 304 is provided within a capacitor forming region 102 on the STI area 14. The metal gated transistor structures 20 and the metal gate structure 304 are fabricated by using the same process flow. Each of the metal gated transistor structures 20 may comprise a metal gate layer 204, a gate dielectric layer 202 underlying the metal gate layer 204, a sidewall spacer 206, source/drain doping regions 103 in the semiconductor substrate 10, and a stressor layer 104 such as SiGe or SiC epitaxially grown on the source/drain doping region 103. A gate dielectric layer 302 is provided between the metal gate structure 304 and the STI area 14. The metal gate layer 204 may comprise metals having different work functions. According to the embodiment, the gate dielectric layers 202 and 302 are composed of the same high-K materials including but not limited to HfO2, HfZrO2, HfSiO4, ZrO2, ZrSiO2, TiO2, Ta2O3. Optionally, an interfacial layer (not shown) such as SiON or SiO2 may be formed before the formation of the gate dielectric layers 202 and 302. The sidewall spacer 206 may comprise silicon nitride or silicon oxynitride.

As previously mentioned, the metal gated transistor structures 20 may be fabricated by using a high-K/gate-last strain enhanced process. Subsequently, a contact etch stop layer (CESL) film 106 is deposited in a blanket manner to cover the surfaces of the metal gate layer 204, the sidewall spacer 206, and the stressor layer 104 within the CMOS region 101, and cover the surfaces of the metal gate structure 304 and sidewall spacer 306 within the capacitor forming region 102. An inter-layer dielectric (ILD) layer 110 is then deposited on the CESL film 106. A polishing process such as a chemical mechanical polishing (CMP) process is carried out to remove the CESL film 106 and the ILD layer 110 from the top surface of the metal gate layer 204 and top surface of the metal gate structure 304. At this point, a planar surface is formed. The polished top surface of the ILD layer 110 is flush with the top surface of the metal gate layer 204 and the top surface of the metal gate structure 304. The sidewall spacers 206 and 306 are made of the same materials.

Subsequently, an etch stop layer 112 is deposited on the planar surface to cover the ILD layer 110, the metal gate layer 204 and the metal gate structure 304. A lithographic process, an etching process, and a contact forming process are performed to form a contact layer 402 within the CMOS region 101 and a contact layer 404 within the capacitor forming region 102. Suitable metals for the contact layers 402 and 404 may include tungsten or alloys containing tungsten, but not limited thereto. The exemplary contact layer 402 penetrates through the etch stop layer 112, the ILD layer 110 and the CESL film 106 to electrically contact the stressor layer 104 and the source/drain doping layer 103. The contact layer 404 is in close proximity to the metal gate structure 304. The contact layer 404 penetrates through the etch stop layer 112, the ILD layer 110 and the CESL film 106 within the capacitor forming region 102 and may slightly recess into the STI area 14.

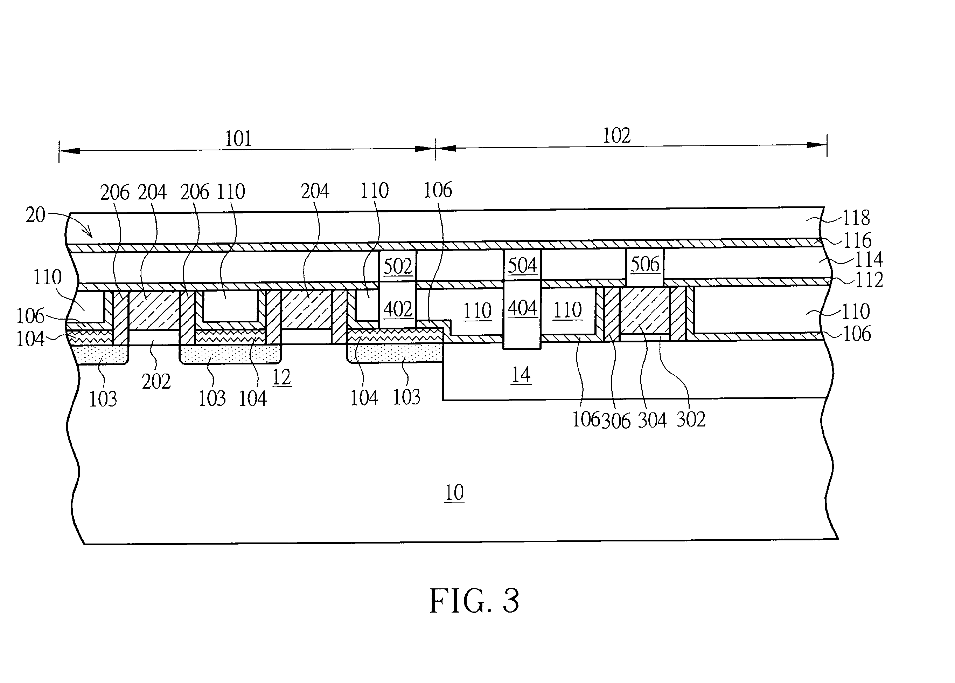

As shown in FIG. 3, an ILD layer 114 is deposited on the etch stop layer 112 and the contact layers 402 and 404. A lithographic process, an etching process, and a contact forming process are performed to form a contact layer 502, a contact layer 504 and contact layer 506 in the ILD layer 114. The contact layer 502 is aligned with the contact layer 402. The contact layer 504 is aligned with the contact layer 404. The contact layer 506 is aligned with the metal gate structure 304. The contact layer 506 penetrates through the etch stop layer 112 to electrically connect with the metal gate structure 304. Subsequently, at least an etch stop layer 116 and an ILD layer 118 are deposited.

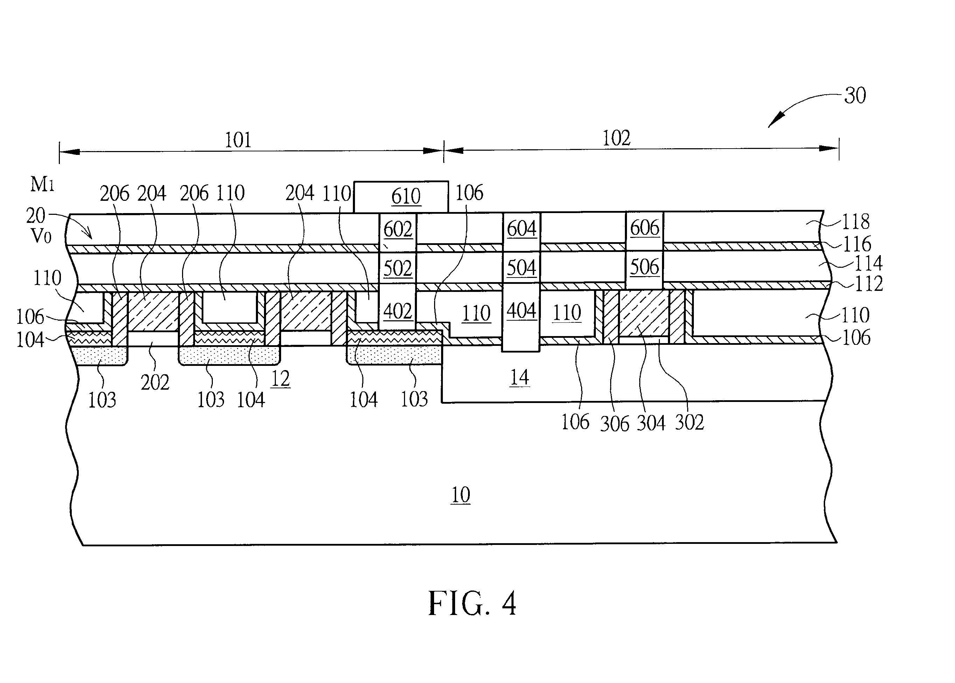

As shown in FIG. 4, a lithographic process, an etching process, and a contact forming process are performed to form a via 602, a via 604 and via 606 in the ILD layer 118 and the etch stop layer 116. The via 602 is aligned with the contact layer 502. The via 604 is aligned with the contact layer 504. The via 606 is aligned with the contact layer 506. The via 602 is in the V0 level and is the via plug interconnecting the contact layer 502 to an interconnection wire 610 in M1 level. The via 602 may be formed integrally with the interconnection wire 610 in M1 level using methods known in the art, for example, copper dual damascene processes. A MOM capacitor 30 is completed.

According to the embodiment, the contact layers 404, 504 constitute one electrode plate of the MOM capacitor 30. The contact layer 506 and the metal gate structure 304 constitute the other electrode plate of the MOM capacitor 30. The ILD layers 110, 114, the etch stop layer 112, the CESL film 106, and the sidewall spacer 306 constitute the capacitor dielectric of the MOM capacitor 30. Due to the two electrode plates are situated in close proximity to one another (space: ~22nm) and the relatively higher dielectric constant of the sidewall spacer 306, the MOM capacitor 30 may has increased capacitance per unit area while occupies relatively smaller amount of chip real estate.

Further, as described through FIGS. 2~4, the fabrication of the MOM capacitor 30 is fully compatible with the current high-K/metal-gate (HK/MG) processes, particularly those high-K/gate-last processes or high-K/gate-last strain enhanced processes, and therefore no extra photo mask is required. Although not shown in FIG. 4, it is to be understood that the MOM capacitor 30 may be stacked by a conventional integrated capacitor formed using the BEOL metal interconnect (M1~Mn).

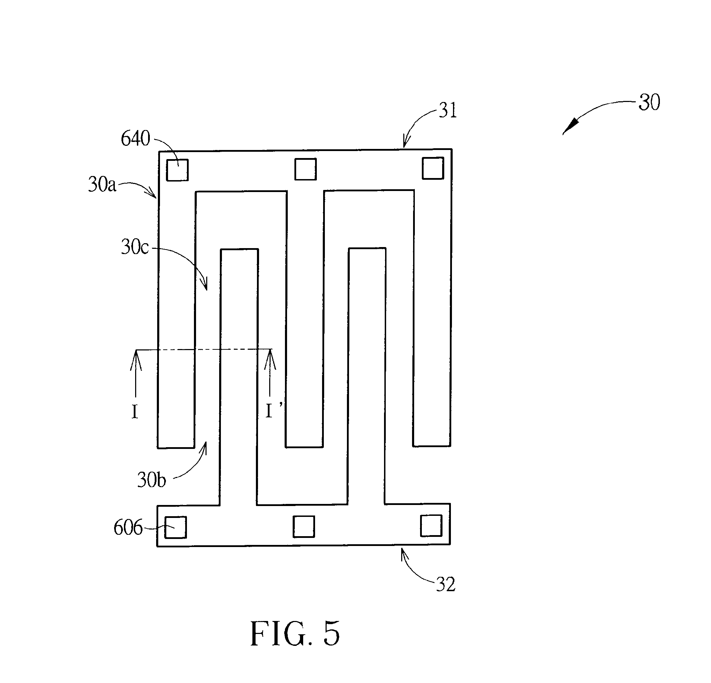

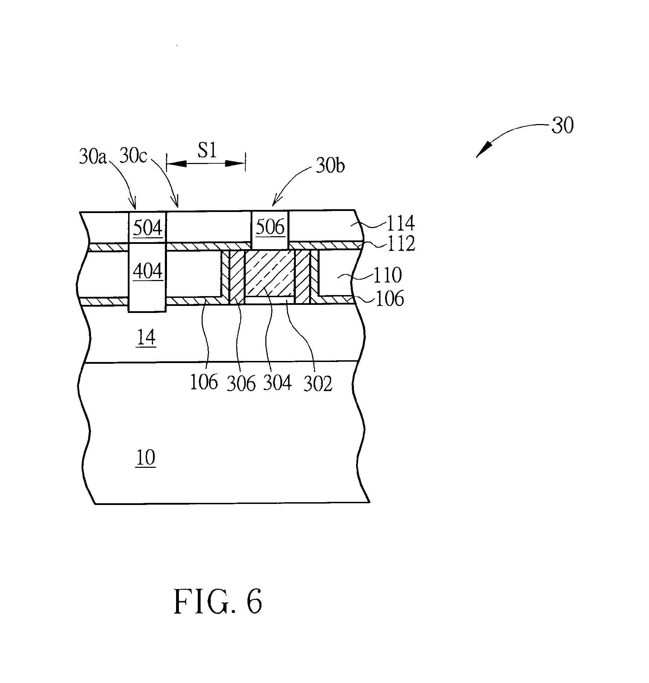

Please refer to FIGS. 5 and FIG. 6, wherein like numeral numbers designate like layers, elements, or regions. FIG. 5 is a schematic layout diagram showing an exemplary MOM capacitor fabricated using the high-K/gate-last process based on the lithographic ground rule, and FIG. 6 is a partial cross-sectional view taken along line I-I' in FIG. 5. As shown in FIG. 5 and FIG. 6, the MOM capacitor 30 is composed of interdigitated first electrode vertical plates (or fingers) 30a and second electrode vertical plates (or fingers) 30b. A capacitor dielectric structure 30c is interposed between the first electrode vertical plate 30a and the second electrode vertical plate 30b. The first electrode vertical plate 30a has a first polarity and the second electrode vertical plate 30b has a second polarity opposite to the first polarity. The first electrode vertical plates (or fingers) 30a are electrically connected to a first connecting bar 31 where multiple vias 604 are formed. The second electrode vertical plates (or fingers) 30b are electrically connected to a second connecting bar 32 where multiple vias 606 are formed.

As previously mentioned, the MOM capacitor 30 is formed on the STI area 14. The first electrode vertical plate 30a comprises the contact layer 404 in the ILD layer 110 and the CESL film 106, and the contact layer 504 in the ILD layer 114 and etch stop layer 112. The second electrode vertical plate 30b comprises the metal gate structure 304 in the ILD layer 110 and the contact layer 506 in the ILD layer 114 and etch stop layer 112. The capacitor dielectric structure 30c comprises the ILD layers 110 and 114, the sidewall spacer 306, the CESL film 106 and the etch stop layer 112. The space S1 between the contact layer 404 and the metal gate structure 304 may be equal to or smaller than 22 nm.

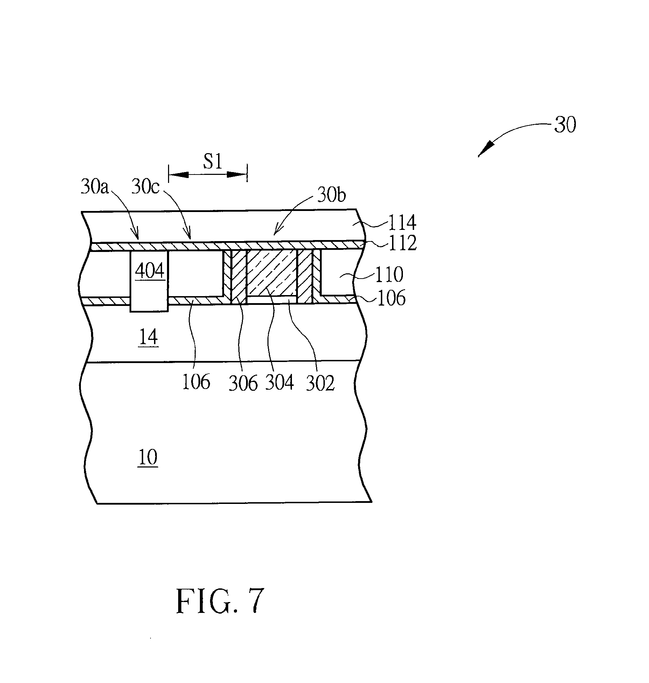

FIGS. 7~10 are schematic, cross-sectional diagrams showing various MOM capacitors in accordance with different embodiments, which are all taken along line I-I' in FIG. 5. As shown in FIG. 7, the first electrode vertical plate 30a comprises only the contact layer 404 in the ILD layer 110 and the CESL film 106. The second electrode vertical plate 30b comprises only the metal gate structure 304 in the ILD layer 110. The capacitor dielectric structure 30c comprises only the ILD layer 110, the sidewall spacer 306, and the CESL film 106.

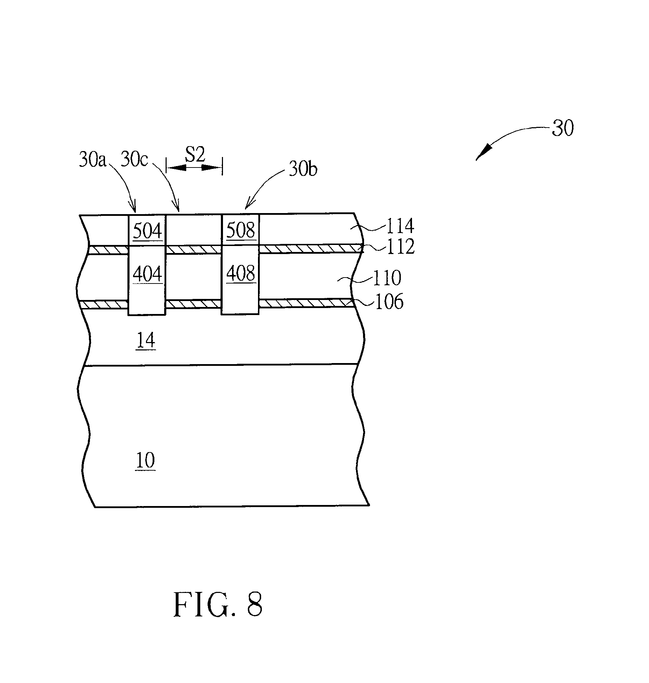

As shown in FIG. 8, the first electrode vertical plate 30a comprises only the contact layer 404 in the ILD layer 110 and the CESL film 106 and the contact layer 504 in the ILD layer 114 and etch stop layer 112. The second electrode vertical plate 30b comprises only the contact layer 408 in the ILD layer 110 and the CESL film 106 and the contact layer 508 in the ILD layer 114 and etch stop layer 112. The capacitor dielectric structure 30c comprises only the ILD layers 110 and 114, the etch stop layer 112, and the CESL film 106. The space S2 between the contact layer 404 and the contact layer 408 may be equal to or smaller than 64 nm.

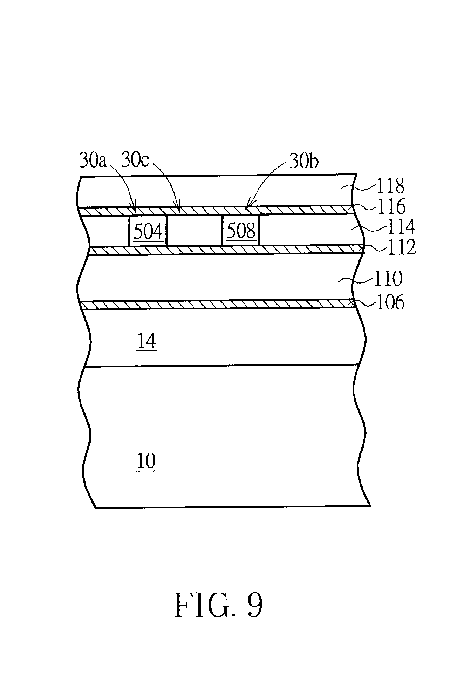

As shown in FIG. 9, the first electrode vertical plate 30a comprises only the contact layer 504 in the ILD layer 114. The second electrode vertical plate 30b comprises only the contact layer 508 in the ILD layer 114. The capacitor dielectric structure 30c comprises only the ILD layer 114.

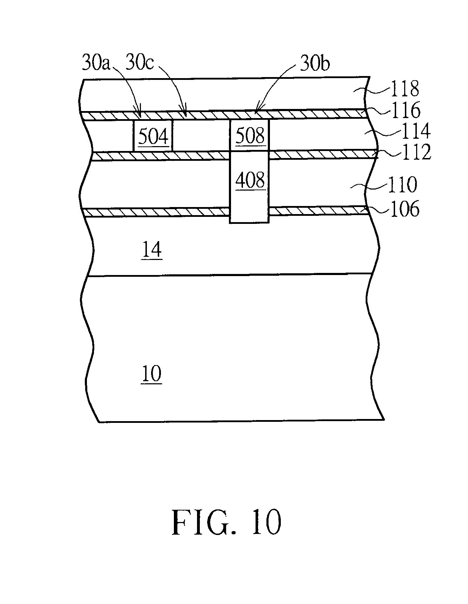

As shown in FIG. 10, the first electrode vertical plate 30a comprises only the contact layer 504 in the ILD layer 114. The second electrode vertical plate 30b comprises the contact layer 408 in the ILD layer 110 and the CESL film 106 and the contact layer 508 in the ILD layer 114. The capacitor dielectric structure 30c comprises the ILD layers 110 and 114, and the etch stop layer 112.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. An integrated capacitor, comprising:
a semiconductor substrate comprising a trench isolation area;
a first interlayer dielectric (ILD) layer covering the trench isolation area;
a first electrode plate comprising at least a first contact layer in the first ILD layer, wherein the contact layer is disposed directly on the trench isolation area;
a second electrode plate in the first ILD layer; and
a capacitor dielectric structure between the first electrode plate and the second electrode plate.

2. The integrated capacitor according to claim 1 wherein the first contact layer is in direct contact with the trench isolation area.

3. The integrated capacitor according to claim 2 wherein the second electrode plate comprises a metal gate structure in the first ILD layer.

4. The integrated capacitor according to claim 3 wherein the capacitor dielectric structure comprises a sidewall spacer on the metal gate structure.

5. The integrated capacitor according to claim 4 wherein the capacitor dielectric structure further comprises a contact etch step layer (CESL) film.

6. The integrated capacitor according to claim 1 wherein the capacitor dielectric structure comprises the first ILD layer.

7. The integrated capacitor according to claim 3 further comprising:
an etch stop layer on the first ILD layer;
a second ILD layer on the etch stop layer;
a second contact layer stacked on the first contact layer; and
a third contact layer on the metal gate structure, wherein the second and third contact layers are both in the second ILD layer.

8. An integrated capacitor, comprising:
a semiconductor substrate comprising a trench isolation area;
an interlayer dielectric (ILD) layer covering the trench isolation area;
a first electrode plate comprising at least a contact layer in the ILD layer;
a second electrode plate in the ILD layer; and
a capacitor dielectric structure between the first electrode plate and the second electrode plate.
